(19) Europäisches Patentamt

European Patent Office

Office européen des brevets

(11) **EP 4 571 330 B1**

(12) **EUROPEAN PATENT SPECIFICATION**

(45) Date of publication and mention
of the grant of the patent:
**05.08.2026 Bulletin 2026/32**

(21) Application number: **23216522.5**

(22) Date of filing: **14.12.2023**

(51) International Patent Classification (IPC):
*G01R 31/08* (2020.01)     *G01R 31/52* (2020.01)

(52) Cooperative Patent Classification (CPC):
**G01R 31/086; G01R 31/52; H02H 3/42;**
**H02H 7/263;** H02H 3/44

(54) **METHOD FOR DETECTING A FAULT, A FAULT PASSAGE INDICATION DEVICE AND A FEEDER LINE**

VERFAHREN ZUR ERKENNUNG EINES FEHLERS,
FEHLERDURCHGANGSANZEIGEVORRICHTUNG UND VERSORGUNGSLEITUNG

PROCÉDÉ DE DÉTECTION D'UN DÉFAUT, DISPOSITIF D'INDICATION DE PASSAGE DE DÉFAUT
ET LIGNE D'ALIMENTATION

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(43) Date of publication of application:
**18.06.2025 Bulletin 2025/25**

(73) Proprietor: **Hitachi Energy Ltd**
**8050 Zürich (CH)**

(72) Inventors:
• **Sinisa, Zubic**
**723 52 Västerås (SE)**
• **Zoran, Gajic**
**723 47 Västerås (SE)**

(74) Representative: **AWA Sweden AB**
**Box 45086**
**104 30 Stockholm (SE)**

(56) References cited:
**EP-A2- 2 733 498     US-A1- 2008 211 511**
**US-A1- 2013 221 977     US-A1- 2019 146 021**

# EP 4 571 330 B1

## Description

<u>Technical field</u>

The present disclosure generally relates to a method for detecting a fault in an alternating current, AC, distribution network having a plurality of phases. The present disclosure further relates to a fault passage indicator device and a feeder line.

<u>Background</u>

The ongoing electrification of various sectors, such as transportation and heating, leads to an increased demand for electricity. As more electric vehicles, electric heating systems, and other electrified technologies become prevalent, the existing power distribution infrastructure may face challenges in meeting the rising demand. By strategically placing substations in feeder lines, utilities can enhance the capacity and efficiency of the distribution network, manage voltage fluctuations, and address the specific requirements of electrification in different regions. This infrastructure expansion helps maintain a stable and resilient power supply system to support the growing electrification trends.

Protection devices are provided to detect faults and to disconnect the full feeder line from the distribution network, until the faulty section is found. When the faulty section is found, this section (or part of the distribution network) can be disconnected, and the power supply can be restored to the other substations. To find the faulty section, different types of fault passage indicators and algorithms are used. One example is the use of voltage measurement together with current measurement for fault passage indication. One further example of a method and device for detecting faults is disclosed in document EP 2 733 498 A2.

However, the existing algorithms require modifications of the substations to provide further voltage measurements and are therefore too expensive and may also have too long faulty section identification time. Thus, there is a need of improved fault passage identification algorithms.

<u>Summary</u>

It is therefore an object of the present disclosure to provide a method for fault passage indication in a substation of an alternating current, AC, distribution network having a plurality of phases that alleviates at least part of the above-mentioned drawbacks. It is for example an object of the present disclosure to provide a method that provides a shorter faulty section identification time and that requires less modifications of the substations. Further, it is an object of the present disclosure to provide a method for identifying fault that is less expensive, simple, and robust.

According to a first aspect of the present disclosure, a method for fault passage indication in a substation of an alternating current, AC, distribution network having a plurality of phases is provided. The method comprises determining a phase current delta value for each phase and calculating a power delta value for each phase based on the determined phase current delta values. The method further comprises integrating each of the power delta values over a time window and determining whether one of the integrated power delta values exceeds a predetermined threshold and the remaining integrated power delta values are below the predetermined threshold within said time window, and if so, indicating a fault passage.

According to a second aspect of the present disclosure, a fault passage indicator device for a substation of an AC distribution network comprising a control unit configured to perform the method according to the first aspect is provided.

According to a third aspect of the present disclosure, a feeder line for an AC distribution network connected to a transformer is provided. The feeder line comprises a plurality of substations each having a transformer and a fault passage indicator device according to the second aspect.

Fault passage identification in the substations of the AC distribution networks is important and there is a particular benefit in obtaining a quick fault passage identification in the substations as the fault passage identification of the substations can be used to determine where the fault is. Further, there is also a benefit in obtaining the location of the fault in order to allow the faulty section in the AC distribution network to be disconnected. When a fault is located, the faulty section can be isolated, and power can be restored to the remaining sections of the AC distribution network. Generally, when a fault occurs, a protection device disconnects the full feeder line to protect the substations and then each substation indicates if there is a fault passage or not. With the present inventive concept, based on the fault passage information, the location of the fault may be identified more rapidly, and the faulty section isolated. Thus, the power can be restored to the remaining sections of the feeder line and thereby the substations, more efficiently.

Many of the existing methods use voltage measurement for fault passage identification. However, even if primary substations may have voltage measurement, commonly all the secondary substations along the feeder line do not have any voltage measurement capabilities due to cost reductions. In contrast, the inventive method provided in the present disclosure allows fault passage identification based on current-only measurements. With current-only measurements, the method does not require investments in voltage measurements in each secondary substation. Therefore, the provided method is more cost-efficient than existing methods based on voltage measurements.

The method determines a phase current delta value for each phase of the AC distribution network. With the phase current delta values, the power delta values can be calculated. By integrating the power delta values over the time window, the integrated power delta values are obtained and can be used for faulty section identification if compared to a predetermined threshold. By implementing this method in each substation, each substation can provide a fault passage identification which together can be used to indicate between which substations the fault is located. This provides a faster identification of the faulty section that relies on rather simple mathematical calculations, which then results in a more robust method. As fault passage can be indicated based on whether only one of the integrated power delta values exceeds the predetermined limit (or predetermined threshold) and the remaining integrated power delta values (for the other phases) are below the predetermined limit, the method does not require any calculation or estimation of fundamental or higher harmonic phasors to detect a fault passage. Therefore, a simpler and more robust method for fault passage identification is provided.

Provided the nature of the current signal (in particular that it follows a sinusoidal form) the method can be repeated, wherein a time window may be provided at every fundamental cycle. The method may for example be repeated in each substation for each time window. When a fault occurs, each substation performing the above-mentioned method can detect if the substation is affected by the fault, i.e., if a fault current is present. If a fault current is present, the substation will indicate a fault passage. It is stressed that a fault passage is only indicated if one of the integrated power delta values exceeds the predetermined threshold. If more than one integrated power delta value exceeds the predetermined threshold, no fault passage is indicated.

It should be noted that the method may use a delta value for each phase current delta value, which is calculated as a difference between two phase current values. By using delta values, a more reliable fault passage indicating criterion is achieved. With a delta value, the changes between the pre-fault value and the post-fault value can be seen.

The time-window used for detecting a fault passage may be the first time-window after a fault inception. The first time-window after the fault inception may be seen by the sharp increase in all the delta values.

The method (or the algorithm) provided herein uses the changes of phase (and residual) phase current delta values ($\Delta$I values), to derive the fault passage indication. Delta values provide a more reliable and more sensitive indicator than the phase currents itself. Additionally, the pre-fault load condition is eliminated from the $\Delta$I signals.

The method (or algorithm) uses a limited time-window to make a decision since the fault passage indication is present only during a short time interval after the fault inception. In case of intermittent faults, it could be only a few milliseconds after the fault ignition. The fault intervals could be followed by long intervals of post-fault transients when fault direction is wrong, and it is preferably not to use such long intervals.

The most reliable fault passage identification is made at the first time-window after the fault inception, which, in other words, is when the first transient of the fault inception occurs. When using only the first time-window after a fault inception, the method may be immune to wrong indications that may occur due to post-fault transient.

The phase current delta value may be determined for each phase as a difference between a first current value sampled at a first time instance and a second current value sampled at a second time instance spaced from the first time instance by one fundamental cycle.

Expressing a phase current delta value as the difference between the first current value and the second current value separated by one fundamental cycle is a practical approach in the analysis of fault identification. It aligns well with the periodic nature of the signals, simplifies frequency domain analysis, and facilitates the extraction of relevant information. Further, the separation by one fundamental cycle ensures that pre- and post-fault values are used when determining the phase current delta values.

One fundamental cycle may also be described as one-cycle period. One fundamental cycle refers to a complete sequence of a periodic waveform over one cycle of the fundamental frequency. The first current value may be the instant value of the current (the current value at an instant time or point in time) and the second current value may be the value of the current one fundamental cycle earlier than the instant time.

Calculating the power delta value for each phase may comprise calculating a delta current reference based on the phase current delta values. The power delta value for each phase may be calculated by multiplying the delta current reference with the respective phase current delta value.

The delta current reference may be used to calculate each power delta value by multiplying each phase current delta value separately with the delta current reference. This results in a respective power delta value for each phase. During the first transient of the fault inception, the polarity of the delta current reference is highly correlated with the polarity of the residual voltage, therefore the delta current reference may act as a good substitution for the residual voltage. This is advantageous as it provides a method for identification of a fault even for substations where there are no voltage measurement capabilities.

The delta current reference may be calculated as a mean value of the phase current delta values. The delta current reference may also be described as the residual current or as a zero sequence. The delta current reference, $\Delta$I$_0$,

may be calculated according to equation 1, where $\Delta I_a$, $\Delta I_b$ and $\Delta I_c$ are the phase current delta values.

$$\Delta I_0 = \frac{(\Delta I_a + \Delta I_b + \Delta I_c)}{3}$$

*Equation 1*

The time window may be one fundamental cycle of the AC distribution network. Integrating each power delta value over a time window of a fundamental cycle may reduce the risk of errors in the decision as to whether a fault passage has occurred or not. The most reliable fault passage indication is present during a short time interval after the fault inception.

The predetermined threshold may be a dynamical threshold. The dynamic threshold changes, or adapts, based on dynamic or changing conditions in the AC distribution network, in particular in relation to the phase of the AC distribution network. This may improve the fault passage identification and thereby enhance the accuracy of the fault detection.

The predetermined threshold may be calculated based on a ratio of a measuring current transformer and a maximum of the integrated power delta value. The current values may be measured by a current transformer, and by combining the ratio of the measuring current transformer and the maximum of the integrated power delta value, a threshold can be determined, which is dynamical and adapt to changes in the AC distribution network. Thereby, the accuracy for detecting fault may be further improved. The ratio of the measuring current transformer is the relationship between a primary current and a secondary current of the current transformer. The primary current is the current flowing through a primary winding of the current transformer, and the secondary current is the current induced in a secondary winding.

The method may further comprise indicating which phase the fault passage occurred in. The method may indicate which of the phases that exceeds the predetermined threshold and thereby the network operator may receive a notification of which phase has encountered a fault. By indicating which phase, the fault passage occurred in, the maintenance time may be reduced.

Each of the plurality of substations in the feeder line may further comprise switches at each side of the substation. The feeder line may further comprise a control system configured to control the switches based on fault information from the fault passage indicator devices to thereby isolate a fault at the feeder line.

The switches may for example be circuit breakers or disconnectors.

With the switches and the control system, the feeder line may automatically isolate the fault based on information from the fault passage indicator devices and by operating the switches. If a fault is between two substations, the switches at the feeder line between the two substations may be operated and the fault isolated.

Effects and features of the second aspect and the third aspect may be largely analogous to those described above in connection with the first aspect. Embodiments mentioned in relation to the first aspect may be at least largely compatible with the second aspect and the third aspect. It is further noted that the present disclosure relates to all possible combinations of features unless explicitly stated otherwise.

A further scope of applicability of the present disclosure will become apparent from the detailed description given below. However, it should be understood that the detailed description and specific examples, while indicating preferred embodiments of the disclosure, are given by way of illustration only, since various changes and modifications within the scope of the disclosure will become apparent to those skilled in the art from this detailed description.

Hence, it is to be understood that the present disclosure is not limited to the particular steps of the method and component parts of the fault passage indicator device and the feeder line described herein. It is also to be understood that the terminology used herein is for the purpose of describing particular embodiments only, and it is not intended to be limiting.

Brief description of the drawings

The present disclosure will by way of example be described in more detail with reference to the appended drawings, which show example embodiments of the disclosure.

Fig. 1    illustrates an AC distribution network having a feeder line with a plurality of substations.

Fig. 2A-B    illustrate an AC distribution network having a feeder line with a plurality of substations with a fault in the AC distribution network.

Fig. 3    illustrates the three phases of the AC distribution network and the plurality of substations, with a fault in the AC distribution network.

Fig. 4    schematically illustrates a method for detecting a fault in the AC distribution network.

Detailed description

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

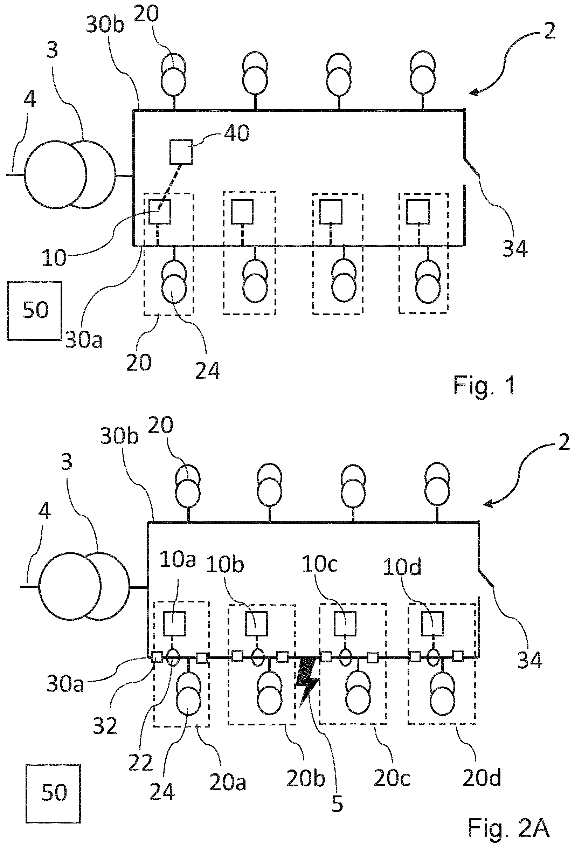

Fig. 1 discloses an alternating current, AC, network 2 comprising two feeder lines 30a, 30b. Each of the feeder lines 30a, 30b comprises four substations 20 having a transformer 24. For not obscuring the figure all components are only denoted for the feeder line 30a. The feeder line 30b comprises the same components as illustrated in feeder line 30a throughout the full description. The AC distribution network 2 is fed by a higher AC distribution network 4 through a primary station transformer 3 which provides the AC distribution network 2 and the respective feeder lines 30a, 30b with power. The feeder lines 30a, 30b provide power to the substations 20, where the transformer 24 of each substation 20 provides a lower AC distribution network with power. As an example, the higher AC distribution network 4 may be a high voltage, HV, AC distribution network and the primary station transformer 3 transforms the power between the HVAC distribution network and a medium voltage AC distribution network 2 in which the substations 20 operate. Each substation 20 may thereafter transform the power from the medium voltage AC distribution network 2 to a respective low voltage network.

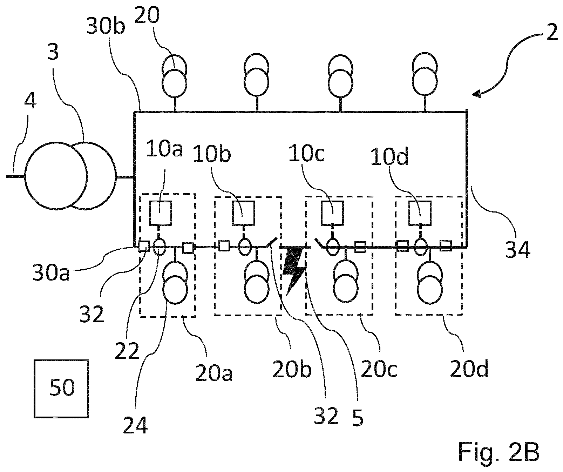

The substations 20 of each feeder lines 30a, 30b are positioned along each feeder line 30a, 30b such that the substations 20 are located one after the other along a radial line. Thereby, a radial AC distribution network 2 is provided. The two feeder lines 30a, 30b are connected by a feeder switch 34 that during normal operation is open. However, as can be seen in Fig. 2b, the feeder switch 34 may close if there is a fault detected in one of the feeder lines 30a, 30b. This will be further discussed in connection to Fig. 2A and 2B.

Each of the substations 20 is provided with a fault passage indicator device 10 that each comprises a control unit 40. In Fig. 1 only one of the control units 40 is illustrated. However, it should be understood that all fault passage indicator devices 10 throughout the figures may comprise one control unit 40. The control unit 40 may in some occasions only be used to detect the fault passage and then the control unit 40 sends a signal to an overhead control system 50 which operates the components of the AC distribution network 2. However, it should be noted that, in some occasion, each control unit 40 may operate the components of the respective substation 20.

Turning to Fig. 2A and 2B, a fault 5 may have occurred in the AC distribution network 2, such as the one described in connection to Fig. 1. In Fig. 2A, the fault 5 has just occurred and in Fig. 2B the control system 50 has isolated the fault 5. The fault 5 may have occurred in a first 30a of the two feeder lines 30a, 30b between two of the substations 20. The substations 20 of the first feeder line 30a include a first substation 20a, a second substation 20b, a third substation 20c and a fourth substation 20d, each comprising a respective fault passage indicator device 10a-d. As can be seen in Fig. 2A and 2B, the fault 5 has occurred between the second and the third substations 20b, 20c.

Each of the plurality of substations 20a-d in the feeder lines further comprises switches 32 at each side of the respective substation 20a-d. As an example, in primary substations circuit breakers may be used and in secondary substations disconnectors may be used. The control system 50 is configured to control the switches based on fault information from the fault passage indicator devices 10a-d to thereby isolate the fault 5 at the feeder line 30a. Each of the substations 20a-d comprises a measuring current transformer 22 which will be further discussed when discussing the fault operation of the fault passage indicator devices 10a-d and the control system 50 below.

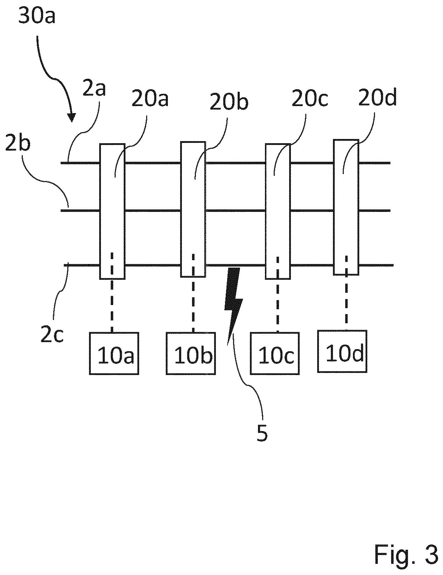

When the fault 5 occurs in the AC distribution network 2, the feeder switch 34 is open, not allowing power to flow. All of the switches 32 are closed and allow power to flow to all of the substations 20a-d. The fault passage indicator devices 10a-d is constantly sensing and trying to detect if a fault occurs. The fault passage indicator devices 10a-d uses the current at each phase 2a-c (the phases are illustrated in Fig. 3) of the AC distribution network 2 to detect if fault passage has occurred.

Each fault passage indicator device 10a-d determines a phase current delta value for each phase 2a-c in the AC distribution network 2. The phase current delta value is determined as a difference between a first current value and a second current value sampled with a time interval. The phase current delta value may be determined for each phase as a difference between a first current value sampled at a first time instance and a second current value sampled at a second time instance spaced from the first time instance by one fundamental cycle. In other words, each fault passage indicator device 10a-d attempts to detect a fault for each time interval or time window, where the time window is one fundamental cycle. One fundamental cycle refers to a complete sequence of a periodic waveform over one cycle of the fundamental frequency. The first current value may be the instant value of the current, i.e., the current at an instant time, and the second current value may be the value of the current one fundamental cycle earlier than the instant time. It is stressed that when a value is determined for each phase it should be understood as that each of the fault passage indicator devices 10a-d determines a respective value for each phase 2a-c of the AC distribution network 2.

With the phase current delta values, the control unit 40 of each fault passage indicator device 10a-d is able to calculate a power delta value for each phase. The respective power delta value is calculated by calculating a delta current reference which is based on the phase current delta values and by multiplying the delta current reference with the respective phase current delta value. The delta current reference may also be referred to as the residual current or as a zero sequence and may, as an example, be calculated according to equation 1 provided in the summary.

The power delta value is thereafter integrated over a time window to achieve a value that is more suitable to be compared to a predetermined threshold. The time window is preferably one fundamental cycle of the AC distribution network, such that the power delta value is integrated over one fundamental cycle. The most reliable fault passage indication is present during a short time interval or during the first transient after the fault inception. During the first transient of the fault inception, the polarity of the delta current reference is highly correlated with the polarity of the residual voltage, therefore the delta current reference may act as a good substitution for the residual voltage. The predetermined threshold can be calculated based on a ratio of the measuring current transformer 22 and a maximum of the integrated power delta value. The current values may be measured by the current transformer 22, and by combining the ratio of the measuring current transformer 22 and the maximum of the integrated power delta value, a threshold can be achieved which is dynamical and can adapt to changes in the AC distribution network 2.

If one of the phases 2a-c of the integrated power delta values exceeds the predetermined threshold and the remaining integrated power delta values are below the predetermined threshold within said time window, a fault passage is indicated. It is stressed that a fault passage is only indicated if one of the phases 2a-c exceeds the predetermined threshold. If more than one phases 2a-c exceeds the predetermined threshold, no fault passage is indicated.

Each fault passage indication device 10a-d is able to detect if a fault passage has occurred. As stated earlier, the fault 5 occurred between the second substation 20b and the third substation 20c, as shown in Fig. 2A and 2B. When the fault 5 occurred, each fault passage indication device 10a-d tests (or makes an identification within) that time window and uses a delta of the pre-fault current value with the post-fault current. In the occasion where the fault 5 is between the second substation 20b and the third substation 20c, the first substation 20a and the second substation 20b will indicate a fault passage. The third substation 20c and the fourth substation will however not indicate a fault passage. With the help of these fault passage indications, the control system 50 may identify the location of the fault and then decide which switches 32 that should be opened. In this case, the switches 32 between the second substation 20b and the third substation 20c are opened and the fault 5 is isolated. This is illustrated in Fig. 2B. When the fault 5 is detected, the feeder switch 34 is closed allowing power to flow from the second feeder line 30b and to the third substation 20c and the fourth substation 20d, thereby the third substation 20c and the fourth substation 20d still have power even in the presence of the fault 5. This allows all the substations 20a-d to be active when the fault 5 is isolated. With the use of fault passage indicator devices 10a-d at each substation 20a-d, the faulty section can be identified and isolated through the switches 32.

Turning to Fig. 3, a feeder line 30a with the three phases 2a-c is illustrated. Substations 20a-d having fault passage indicator devices 10a-d are provided along the feeder line 20a. Each of the fault passage indicator devices 10a-d may detect faults for each phase 2a-c. Thereby, a fault passage indicator device 10a-d can indicate at which of the phases 2a-c the fault 5 is present. As can be seen in Fig. 3, the fault 5 is at the third phase 2c. In other words, each fault passage indicator device 10a-d indicates which of the phases 2a-c that exceeds the predetermined threshold and thereby the network operator may receive a notification of which phase 2a-c has encountered a fault.

With the switches 32 and the control system 50, described in connection to Fig. 2A-2B, the feeder line 10a may automatically isolate the fault based on information from the fault passage indicator devices 10a-d by operating the switches 32, as described above.

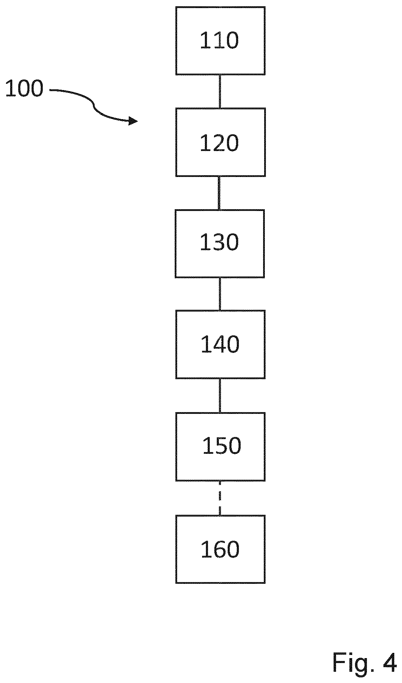

In Fig. 4 a method 100 for detecting a fault 5 in an alternating current, AC, distribution network 2 having a plurality of phase 2a-c s is schematically illustrated. The method 100 is the method used in the fault passage indicator devices 10a-c, such as described above. The method 100 comprises determining 110 a phase current delta value for each phase and calculating 120 a power delta value for each phase based on the determined phase current delta values. The method 100 further comprises integrating 130 each of the power delta values over a time window and determining 140 whether one of the integrated power delta values exceeds a predetermined threshold and whether the remaining integrated power delta values are below the predetermined threshold within said time window, and if so, indicating 150 a fault passage. In other words, if one of the integrated power delta values exceeds the predetermined threshold and the other integrated power delta values (for the other phases) are below the predetermined threshold, there will be an indication of a fault passage.

The method 100 may further comprise indicating 150 in which phase 2a-c the fault passage occurred. In other words, the method 100 may indicate which of the phases 2a-c that exceeds the predetermined threshold.

The person skilled in the art realizes that the present disclosure by no means is limited to the preferred embodiments described above. On the contrary, many modifications and variations are possible within the scope of the appended claims.

## Claims

1. A method (100) for fault passage indication in a substation (20) of an alternating current, AC, distribution network (2)

having a plurality of phases (2a-2c), the method comprising:

determining (110) a phase current delta value for each phase,
**characterised in that** the method further comprises:

calculating (120) a power delta value for each phase based on the determined phase current delta values,
integrating (130) each of the power delta values over a time window,
determining (140) whether one of the integrated power delta values exceeds a predetermined threshold and the remaining integrated power delta values are below the predetermined threshold within said time window, and
if so, indicating (150) a fault passage.

2. The method according to claim 1, wherein the phase current delta value is determined for each phase as a difference between a first current value sampled at a first time instance and a second current value sampled at a second time instance spaced from the first time instance by one fundamental cycle.

3. The method according to any one of the preceding claims, wherein calculating the power delta value for each phase comprises:

calculating (120a) a delta current reference based on the phase current delta values,
wherein the power delta value for each phase is calculated by multiplying (120b) the delta current reference with the respective phase current delta value.

4. The method according to claim 3, wherein the delta current reference is calculated as a mean value of the phase current delta values.

5. The method according to any one of the preceding claims, wherein the time window is one fundamental cycle of the AC distribution network.

6. The method according to any one of the preceding claims, wherein the predetermined threshold is a dynamical threshold.

7. The method according to any one of the preceding claims, wherein the predetermined threshold is calculated based on a ratio of a measuring current transformer and a maximum of the integrated power delta value.

8. The method according to any one of the preceding claims, further comprising indicating (160) which phase the fault passage occurred in.

9. A fault passage indicator device (10) for a substation (20) of an AC distribution network (2) comprising a control unit (40) configured to perform the method (100) according to any one of claims 1 to 8.

10. A feeder line (30a) for an AC distribution network (2) connected to a transformer (3), the feeder line comprising:
a plurality of substations (20) each having a transformer (24) and a fault passage indicator device (10) according to claim 9.

11. The feeder line according to claim 10, wherein each of the plurality of substations further comprises switches (32) at each side of the substation, and wherein the feeder line further comprises a control system (50) configured to control the switches based on fault information from the fault passage indicator devices to thereby isolate a fault at the feeder line.

**Patentansprüche**

1. Verfahren (100) zur Fehlerdurchgangsanzeige in einer Umspannstation (20) eines Wechselstrom-Verteilungsnetzwerks, AC-Verteilungsnetzwerks, (2) mit einer Mehrzahl von Phasen (2a-2c), wobei das Verfahren Folgendes umfasst:
Bestimmen (110) eines Phasenstrom-Delta-Werts für jede Phase, **dadurch gekennzeichnet, dass** das Verfahren ferner Folgendes umfasst:

Berechnen (120) eines Leistungs-Delta-Werts für jede Phase basierend auf den bestimmten Phasenstrom-Delta-Werten,

Integrieren (130) jedes der Leistungs-Delta-Werte über ein Zeitfenster,

Bestimmen (140), ob einer der integrierten Leistungs-Delta-Werte einen vorbestimmten Schwellenwert überschreitet und die verbleibenden integrierten Leistungs-Delta-Werte innerhalb des Zeitfensters unter dem vorbestimmten Schwellenwert liegen, und

falls ja, Anzeigen (150) eines Fehlerdurchgangs.

2. Verfahren nach Anspruch 1, wobei der Phasenstrom-Delta-Wert für jede Phase als eine Differenz zwischen einem ersten Stromwert, der zu einem ersten Zeitpunkt abgetastet wird, und einem zweiten Stromwert bestimmt wird, der zu einem zweiten Zeitpunkt abgetastet wird, der vom ersten Zeitpunkt um einen Grundzyklus versetzt ist.

3. Verfahren nach einem der vorhergehenden Ansprüche, wobei das Berechnen des Leistungs-Delta-Werts für jede Phase Folgendes umfasst:

Berechnen (120a) einer Delta-Stromreferenz basierend auf den Phasenstrom-Delta-Werten,

wobei der Leistungs-Delta-Wert für jede Phase durch Multiplizieren (120b) der Delta-Stromreferenz mit dem jeweiligen Phasenstrom-Delta-Wert berechnet wird.

4. Verfahren nach Anspruch 3, wobei die Delta-Stromreferenz als ein Mittelwert der Phasenstrom-Delta-Werte berechnet wird.

5. Verfahren nach einem der vorhergehenden Ansprüche, wobei das Zeitfenster ein Grundzyklus des AC-Verteilungsnetzwerks ist.

6. Verfahren nach einem der vorhergehenden Ansprüche, wobei der vorbestimmte Schwellenwert ein dynamischer Schwellenwert ist.

7. Verfahren nach einem der vorhergehenden Ansprüche, wobei der vorbestimmte Schwellenwert basierend auf einem Verhältnis eines Messstromwandlers und eines Maximums des integrierten Leistungs-Delta-Werts berechnet wird.

8. Verfahren nach einem der vorhergehenden Ansprüche, ferner umfassend Anzeigen (160), in welcher Phase der Fehlerdurchgang aufgetreten ist.

9. Fehlerdurchgangsanzeigevorrichtung (10) für eine Umspannstation (20) eines AC-Verteilungsnetzwerks (2), umfassend eine Steuereinheit (40), die dazu ausgelegt ist, das Verfahren (100) nach einem der Ansprüche 1 bis 8 durchzuführen.

10. Speiseleitung (30a) für ein AC-Verteilungsnetzwerk (2), die mit einem Transformator (3) verbunden ist, wobei die Speiseleitung Folgendes umfasst:
eine Mehrzahl von Umspannstationen (20), die jeweils einen Transformator (24) und eine Fehlerdurchgangsanzeigevorrichtung (10) nach Anspruch 9 aufweisen.

11. Speiseleitung nach Anspruch 10, wobei jede der Mehrzahl von Umspannstationen ferner Schalter (32) auf jeder Seite der Umspannstation umfasst und wobei die Speiseleitung ferner ein Steuersystem (50) umfasst, das dazu ausgelegt ist, die Schalter basierend auf Fehlerinformationen von den Fehlerdurchgangsanzeigevorrichtungen zu steuern, um dadurch einen Fehler an der Speiseleitung zu isolieren.

**Revendications**

1. Procédé (100) d'indication de passage de défaut dans une sous-station (20) d'un réseau (2) de distribution à courant alternatif, AC, comportant une pluralité de phases (2a-2c), le procédé comprenant :
la détermination (110) d'une valeur différentielle de courant de phase pour chaque phase, **caractérisé en ce que** le procédé comprend en outre :

le calcul (120) d'une valeur différentielle de puissance pour chaque phase à partir des valeurs différentielles de courant de phase déterminées,

l'intégration (130) de chacune des valeurs différentielles de puissance sur une fenêtre temporelle, le fait de déterminer (140) si une des valeurs différentielles de puissance intégrées dépasse un seuil prédéterminé et si les valeurs différentielles de puissance intégrées restantes sont inférieures au seuil prédéterminé à l'intérieur de ladite fenêtre temporelle, et

si oui, le fait d'indiquer (150) un passage de défaut.

2.  Procédé selon la revendication 1, la valeur différentielle de courant de phase étant déterminée pour chaque phase comme une différence entre une première valeur de courant échantillonnée à un premier instant et une seconde valeur de courant échantillonnée à un second instant espacé d'un cycle fondamental par rapport au premier instant.

3.  Procédé selon l'une quelconque des revendications précédentes, le calcul de la valeur différentielle de puissance pour chaque phase comprenant :

    le calcul (120a) d'une référence de courant différentiel sur la base des valeurs différentielles de courant de phase, la valeur différentielle de puissance pour chaque phase étant calculée en multipliant (120b) la référence de courant différentiel par la valeur différentielle de courant de phase respective.

4.  Procédé selon la revendication 3, la référence de courant différentiel étant calculée en tant que valeur moyenne des valeurs différentielles de courant de phase.

5.  Procédé selon l'une quelconque des revendications précédentes, la fenêtre temporelle étant un cycle fondamental du réseau de distribution AC.

6.  Procédé selon l'une quelconque des revendications précédentes, le seuil prédéterminé étant un seuil dynamique.

7.  Procédé selon l'une quelconque des revendications précédentes, le seuil prédéterminé étant calculé sur la base d'un rapport d'un transformateur de courant de mesure et d'un maximum de la valeur différentielle de puissance intégrée.

8.  Procédé selon l'une quelconque des revendications précédentes, comprenant en outre l'indication (160) de la phase dans laquelle le passage de défaut s'est produit.

9.  Dispositif indicateur (10) de passage de défaut pour une sous-station (20) d'un réseau (2) de distribution AC comprenant une unité (40) de commande configurée pour réaliser le procédé (100) selon l'une quelconque des revendications 1 à 8.

10. Ligne (30a) d'alimentation pour réseau (2) de distribution AC connectée à un transformateur (3), la ligne d'alimentation comprenant :
    une pluralité de sous-stations (20) ayant chacune un transformateur (24) et un dispositif indicateur (10) de passage de défaut selon la revendication 9.

11. Ligne d'alimentation selon la revendication 10, chacune de la pluralité de sous-stations comprenant en outre des commutateurs (32) de chaque côté de la sous-station, et la ligne d'alimentation comprenant en outre un système (50) de commande configuré pour commander les commutateurs sur la base d'informations de défaut provenant des dispositifs indicateurs de passage de défaut pour ainsi isoler un défaut au niveau de la ligne d'alimentation.

Fig. 1

Fig. 2A

Fig. 2B

Fig. 3

Fig. 4

**REFERENCES CITED IN THE DESCRIPTION**

**Patent documents cited in the description**

• EP 2733498 A2